(19) Europäisches Patentamt
European Patent Office
Office européen des brevets

(11) EP 3 188 267 A1

(12) EUROPEAN PATENT APPLICATION
published in accordance with Art. 153(4) EPC

(43) Date of publication:
**05.07.2017 Bulletin 2017/27**

(21) Application number: **15834300.4**

(22) Date of filing: **10.07.2015**

(51) Int Cl.:
***H01L 41/193*** *(2006.01)* ***C08J 5/18*** *(2006.01)*

(86) International application number:
**PCT/JP2015/069959**

(87) International publication number:
**WO 2016/027587 (25.02.2016 Gazette 2016/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **22.08.2014 JP 2014169671**

(71) Applicant: **Mitsui Chemicals, Inc.**
**Minato-ku**
**Tokyo 105-7122 (JP)**

(72) Inventors:
- **TANIMOTO, Kazuhiro**
  **Nagoya-shi**
  **Aichi 457-8522 (JP)**
- **SATO, Keisuke**
  **Nagoya-shi**
  **Aichi 457-8522 (JP)**
- **KITAGAWA, Toshihisa**
  **Nagoya-shi**
  **Aichi 457-8522 (JP)**
- **OZAKI, Katsutoshi**
  **Nagoya-shi**
  **Aichi 457-8522 (JP)**

(74) Representative: **Hoffmann Eitle**
**Patent- und Rechtsanwälte PartmbB**
**Arabellastraße 30**
**81925 München (DE)**

# (54) POLYMERIC PIEZOELECTRIC FILM

(57) Provided is a polymeric piezoelectric film containing an optically active helical chiral polymer (A) having a weight average molecular weight of from 50,000 to 1,000,000, in which a crystallinity obtained by a DSC method is from 20% to 80%, and the product of the crystallinity and a standardized molecular orientation MORc when a reference thickness measured by a microwave transmission-type molecular orientation meter is set to 50 μm is from 25 to 700, and in which a surface roughness of at least one plane in terms of a non-contact three-dimensional surface roughness Sa measured by a confocal laser microscope is from 0.040 μm to 0.105 μm.

EP 3 188 267 A1

## Description

### Technical Field

The present invention relates to a polymeric piezoelectric film.

### Background Art

Recently, application of a helical chiral polymeric piezoelectric film to a device such as a sensor or an actuator is studied. When such a device is mass-produced, a long-length film wound in a roll or a helical chiral polymeric piezoelectric material in a roll body is used from the viewpoint of productivity.

For example, blocking of a biaxially oriented helical chiral polymer film or a roll body without piezoelectricity is known to be prevented by controlling the surface roughness (see, for example, Documents 1 to 3).

Document 1 Japanese Patent Application Laid-Open (JP-A) No. 2000-044701
Document 2 JP-A No. 2001-059029
Document 3 JP-A No. 2009-285865

## SUMMARY OF INVENTION

### Technical Problem

The present inventors, however, have found that appearance characteristics of a polymeric piezoelectric film extremely deteriorate although blocking properties are favorable due to favorable smoothness between the films even when simply the surface roughness of a polymeric piezoelectric film is large. Specifically, the present inventors have found that the appearance of a polymeric piezoelectric film may deteriorate by air inclusion at the interface of the films when the films are stuck together.

On the other hand, when the surface roughness of a polymeric piezoelectric film is small, a surface charge caused by piezoelectric characteristics is generated when a stress is applied to the polymeric piezoelectric film. As a result, a polymeric piezoelectric film is likely to adsorb a dust, and there are concerns that the quality of the film deteriorates.

When a polymeric piezoelectric film is used, for example, as a sensor or an actuator, not only does the appearance deteriorate, but malfunction of a sensor or an actuator may occur due to air inclusion or a foreign matter such as a dust.

The invention has been made in view of the above-described problems, and an object of the invention is to provide a polymeric piezoelectric film in which generation of a surface charge is suppressed and the appearance after sticking together is excellent. Solution to Problem

Specific means to solve a problem are as follows.

<1> A polymeric piezoelectric film containing an optically active helical chiral polymer (A) having a weight average molecular weight of from 50,000 to 1,000,000, in which a crystallinity obtained by a DSC method is from 20% to 80%, and a product of the crystallinity and a standardized molecular orientation MORc, when a reference thickness measured by a microwave transmission-type molecular orientation meter is set to 50 μm is from 25 to 700, and in which a surface roughness of at least one plane in terms of a non-contact three-dimensional surface roughness Sa measured by a confocal laser microscope is from 0.040 μm to 0.105 μm.

<2> The polymeric piezoelectric film according to <1>, in which an internal haze for visible light is 40% or less, and a piezoelectric constant $d_{14}$ measured by a stress-electric charge method at 25°C is 1 pC/N or more.

<3> The polymeric piezoelectric film according to <1> or <2>, in which an internal haze for visible light is 20% or less.

<4> The polymeric piezoelectric film according to any one of <1> to <3>, in which the product of the crystallinity and the standardized molecular orientation MORc is from 40 to 700.

<5> The polymeric piezoelectric film according to any one of <1> to <4>, in which the helical chiral polymer (A) is a polylactic acid polymer having a repeating unit represented by the following Formula (1)

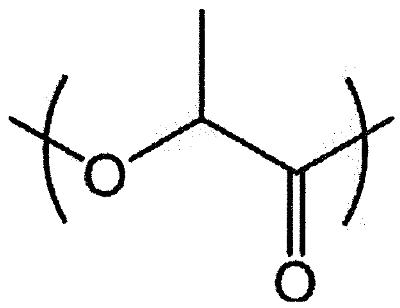

(1)

<6> The polymeric piezoelectric film according to any one of <1> to <5>, in which the helical chiral polymer (A) has an optical purity of 95.00%ee or more.

<7> The polymeric piezoelectric film according to any one of <1> to <6>, in which a content of the helical chiral polymer (A) is 80% by mass or more.

<8> The polymeric piezoelectric film according to any one of <1> to <7>, in which an internal haze for visible light is 1% or less.

[Advantageous Effects of Invention]

According to the invention, a polymeric piezoelectric film in which generation of a surface charge is suppressed and the appearance after sticking together is excellent can be provided.

DESCRIPTION OF EMBODIMENTS

Here, a numerical range represented by "from A to B" means a range including numerical values A and B as a lower limit value and an upper limit value, respectively.

Here, a "film" is a concept including a so-called "sheet" as well as a so-called "film".

[Polymeric piezoelectric Film]

In the following, a polymeric piezoelectric film according to one embodiment of the invention will be described. A polymeric piezoelectric film according to the present embodiment is a polymeric piezoelectric film containing an optically active helical chiral polymer (A) having a weight average molecular weight of from 50,000 to 1,000,000, in which a crystallinity obtained by a DSC method is from 20% to 80%, and a product of the crystallinity and a standardized molecular orientation MORc when a reference thickness measured by a microwave transmission-type molecular orientation meter is set to 50 μm is from 25 to 700, and in which a surface roughness of at least one plane in terms of a non-contact three-dimensional surface roughness Sa measured by a confocal laser microscope is from 0.040 μm to 0.105 μm.

Since a polymeric piezoelectric film of the present embodiment containing an optically active helical chiral polymer having a weight average molecular weight of from 50,000 to 1,000,000, a crystallinity obtained by a DSC method is from 20% to 80%, and the product of the crystallinity and a standardized molecular orientation MORc when a reference thickness measured by a microwave transmission-type molecular orientation meter is set to 50 μm is from 25 to 700, generation performance of oriented crystal, mechanical strength, dimension stability, and transparency are excellent. Further, in this embodiment, a polymeric piezoelectric film of the present embodiment maintains to have a high piezoelectricity to some extent.

Further, since a polymeric piezoelectric film of the present embodiment has a non-contact three-dimensional surface roughness Sa of 0.105 μm or less, an air inclusion between surfaces on which the polymeric piezoelectric films are stuck together does not occur and the appearance after sticking together is excellent. Further, since a polymeric piezoelectric film of the present embodiment has a non-contact three-dimensional surface roughness Sa of 0.040 μm or more, a surface charge caused by piezoelectric characteristics generated when a stress is applied to the polymeric piezoelectric film is suppressed, and as a result, attachment of a dust or the like on the surface is suppressed, and a high quality can be maintained.

< Non-contact Three-dimensional Surface Roughness Sa >

The surface roughness of at least one plane of a polymeric piezoelectric film of the present embodiment in terms of a non-contact three-dimensional surface roughness Sa measured by a confocal laser microscope is from 0.040 μm to 0.105 μm. By this, a large air inclusion when a polymeric piezoelectric film and another member (for example,

OCA; Optical Clear Adhesive) are stuck together is suppressed, and the appearance is excellent.

The non-contact three-dimensional surface roughness Sa of a polymeric piezoelectric film of the present embodiment is preferably from 0.040 μm to 0.102 μm, more preferably from 0.040 μm to 0.100 μm, still more preferably from 0.042 μm to 0.098 μm, and particularly preferably from 0.045 μm to 0.095 μm.

The non-contact three-dimensional surface roughness Sa can be calculated as follows.

Platinum is sputtered on a measuring surface of a polymeric piezoelectric film of the present embodiment by using a sputtering apparatus (J-1000 manufactured by ULVAC, Inc.), and then, a non-contact three-dimensional surface roughness Sa is calculated in accordance with ISO 25178 from the result of image analysis in an area of 645 μm × 644 μm by using a confocal laser microscope (LEXT OLS 4000 manufactured by Olympus Corporation, objective lens ×20). Specifically, this measurement is performed on three points in the measuring surface of the film, and the measured values are averaged to obtain a non-contact three-dimensional surface roughness Sa. Here, the measuring surface of the film refers to a principal plane, corresponding to a surface in contact with a member such as a roll during manufacturing of a polymeric piezoelectric film, a surface on which a surface treatment such as a roughening treatment or a smoothing treatment is performed, a surface of a polymeric piezoelectric film on which a hard coat layer is formed, or the like. When a hard coat layer is formed on one surface of a polymeric piezoelectric film, the surface corresponds to a measuring surface of the film, and when hard coat layers are formed on both sides of a polymeric piezoelectric film, either side of the surfaces of the film may be a measuring surface of the film.

In a polymeric piezoelectric film of the present embodiment, the Sa of the larger non-contact three-dimensional surface roughness Sa of the two principal planes is preferably from 0.040 μm to 0.105 μm. By this, a large air inclusion is suppressed when a polymeric piezoelectric film is stuck with another member (for example, OCA; Optical Clear Adhesive), and a more excellent appearance is obtained. The surface roughness of the smaller non-contact three-dimensional surface roughness Sa of the two principal planes is not particularly limited. When the Sa of the larger non-contact three-dimensional surface roughness Sa of the two principal planes is from 0.040 μm to 0.105 μm, blocking can be suitably suppressed, and the appearance after sticking together is excellent.

Examples of a measurement method of a surface roughness include a contact type method as well as a non-contact type method of the present embodiment. In a contact type method, a sample needs to be in contact with, which may cause occurrence of contamination or a damage of the surface of an object to be measured. In a non-contact type method, such contamination or a damage of the surface of an object to be measured can be suppressed, which is preferable. Since the surface hardness of a polymeric piezoelectric film containing a helical chiral polymer is low, a more accurate evaluation is possible by employing a non-contact type method.

A non-contact three-dimensional surface roughness Sa can be controlled, for example, by addition of an additive, cooling conditions after melting (a cooling temperature, a surface roughness of a member in contact with during cooling), heat treatment conditions (for example, heating method, heating temperature, heating time, surface roughness of a member in contact with during heating) before stretching (preheating) and/or after stretching (annealing), stretching conditions (for example, stretching ratio, stretching temperature, stretching speed), a surface treatment on a polymeric piezoelectric film, or the like when a polymeric piezoelectric film is manufactured.

Examples of the additive include an inorganic material (a filler or the like), or an organic material (a lubricant, a nucleating agent, or the like), or a polymer material which is different from a polymer contained in a polymeric piezoelectric film. By formation of a domain of such an additive present on the surface of a polymeric piezoelectric film, the surface roughness can be controlled. From the viewpoint of increasing the dispersion in the film and the transparency of the film, the particle size of an additive is preferably in a range in which the additive is in a highly dispersed state, and is preferably, for example, about from 0.01 μm to 0.5 μm.

Examples of cooling conditions include a cooling temperature when a polymeric piezoelectric film is formed by melting and then is cooled or the surface roughness of a member (for example, a cast roll) in contact with during cooling. In general, when a cooling temperature is high, a film is likely to be affected by the surface roughness of a member in contact with during cooling. Being likely to be affected by the surface roughness refers to tendencies that, when the surface roughness of a member in contact with is high, the surface roughness of a polymeric piezoelectric film tends to be high, and when the surface roughness of a member in contact with is low, the surface roughness of the polymeric piezoelectric film tends to be low.

Examples of a heating method include roll heating optical heating such as IR heating or hot air heating in a furnace. In general, while, in roll heating, a film is likely to be affected by the surface roughness of a roll, in optical heating or hot air heating in a furnace, a film is less likely to be affected by the surface roughness of a roll before and after heating even by roll-to-roll, and the surface roughness tends to be low.

Examples of stretching conditions include a stretching ratio, a stretching temperature, or a stretching speed. These conditions change the modulus of elasticity of the outermost surface of a polymeric piezoelectric film, and the way how the outermost surface is affected by the surface roughness of a roll.

Examples of a surface treatment to a polymeric piezoelectric film include a roughening treatment or a smoothing treatment. Examples of a roughening treatment include a sandblast treatment, an etching treatment by a liquid which

dissolves or swells the surface of a polymeric piezoelectric film, or a treatment of contacting a polymeric piezoelectric film with a member having a high surface roughness at a temperature which is a glass transition temperature of the polymeric piezoelectric film or more. Examples of a smoothing treatment include a grinding treatment, a treatment of contacting a polymeric piezoelectric film with a member having a low surface roughness at a temperature which is a glass transition temperature of the polymeric piezoelectric film or more, or a treatment of forming a coating layer on a polymeric piezoelectric film.

A coating layer refers to a layer which exists on the surface of a polymeric piezoelectric film and at least a part of which is in contact with the polymeric piezoelectric film. The material of the coating layer is not particularly limited, and preferably contains at least one material selected from the group consisting of an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acryl hybrid compound, a silica-epoxy hybrid compound, a metal, and a metal oxide. Among these, an acrylic compound, an epoxy compound, a silane compound, and a metal oxide are more preferable.

Two or more coating layers may be layered. A coating layer may have a function other than smoothing the surface of a polymeric piezoelectric film, and examples of such a functional layer include an easy adhesive layer, a hard coat layer, a refractive index adjusting layer, an antireflection layer, an antiglare layer, an easily slippable layer, an antiblock layer, a protective layer, an adhesive layer, a pressure sensitive adhesive layer, an antistatic layer, a heat dissipation layer, an ultraviolet absorbing layer, an anti-Newton ring layer, a light scattering layer, a polarizing layer, a gas barrier layer, or a hue adjusting layer. As a method of forming a coating layer, it is possible to use a publicly known method which has been conventionally and generally used, if appropriate. Examples thereof include a wet coating method.

A coating layer can be formed by applying a coating liquid in which a material such as an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acryl hybrid compound, a silica-epoxy hybrid compound, a metal, or a metal oxide is dispersed or dissolved and, if necessary, by drying and removing an unnecessary solvent.

Furthermore, if necessary, the coating layer is cured by irradiating the material with heat or an active energy ray (an ultraviolet ray, an electron beam, radiation, or the like). When the coating layer contains a cured product of a curable compound, by reducing the equivalent amount of a polymerizable functional group of the curable compound (that is, by increasing the number of polymerizable functional groups contained in unit molecular weight of the curable compound), the crosslinking density is increased. As a material contained in the coating layer, a cured product having a three-dimensional crosslinked structure is preferable among the above-described cured products. A coating layer having such a three-dimensional crosslinked structure preferably contains a (meth)acrylic compound having three or more (meth)acrylic groups in one molecule thereof. Herein, a "(meth)acrylic group" refers to at least one of an acrylic group or a methacrylic group.

< Charged Voltage >

Since the above-described non-contact three-dimensional surface roughness Sa of a polymeric piezoelectric film of the present embodiment is from 0.040 μm to 0.105 μm, the appearance after sticking together is excellent, and also generation of a surface charge is suppressed. Whether generation of a surface charge of a polymeric piezoelectric film is suppressed can be determined by measuring a charged voltage of the polymeric piezoelectric film by the following method.

First, two 100 mm square films are cut out from a roll-shaped polymeric piezoelectric film, electric charges on the surface of the films are cancelled by IONIZER MODEL 10/10 manufactured by Hugle Electronics Inc., and then the two films are laminated in such a way that the frontside and the backside of the two films are in contact with each other to be press-bonded by a 2 kg-load roll in a constant direction for ten times. Then, the two films are peeled from each other under an atmosphere at 20°C × 40%RH at a rate of 10 m/min, and a charged voltage (kV) of the film is measured with DIGITAL STATIC METER KSD-1000 manufactured by KASUGA ELECTRIC WORKS LTD.

The charged voltage measured as above is preferably 6.8 kV or less, more preferably 6.5 kV or less, still more preferably 6.0 kV or less, and particularly preferably 5.0 kV or less. When the charged voltage is in the above-described numerical range, attachment of a dust or the like on the surface of a polymeric piezoelectric film is suppressed.

Although the lower limit of the charged voltage is not particularly limited, since, when the value of the charged voltage is reduced, the value of the non-contact three-dimensional surface roughness Sa is increased, and an air inclusion may be likely to occur between the surfaces of the polymeric piezoelectric films which are stuck together, the charged voltage is preferably 1.0 kV or more, more preferably 1.5 kV or more, still more preferably 2.0 kV or more, and particularly preferably 2.2 kV or more.

< Standardized Molecular Orientation MORc >

The standardized molecular orientation MORc is a valued based on "degree of molecular orientation MOR" which is an indication representing a degree of orientation of the helical chiral polymer (A).

Here, the degree of molecular orientation MOR (Molecular Orientation Ratio) is measured by the following microwave measure method. That is, a polymeric piezoelectric film is placed in a microwave resonant waveguide of a well-known microwave molecular orientation ratio measuring apparatus (also referred to as a "microwave transmission-type molecular orientation meter") such that the surface of the polymeric piezoelectric film (film surface) is perpendicular to a traveling direction of the microwaves. Then, while the polymeric piezoelectric film is continuously irradiated with microwaves an oscillating direction of which is biased unidirectionally, the sample is rotated in a plane perpendicular to the traveling direction of the microwaves from 0 to 360°, and the intensity of the microwaves which have passed through the sample is measured to determine the molecular orientation ratio MOR.

The standardized molecular orientation MORc means a degree of molecular orientation MOR obtained based on the reference thickness tc of 50 μm, and can be determined by the following formula.

$$MORc = (tc/t) \times (MOR - 1) + 1$$

(tc: reference thickness to which the thickness should be corrected; t: thickness of polymeric piezoelectric film)

The standardized molecular orientation MORc can be measured by a known molecular orientation meter, for example, a microwave molecular orientation meter MOA-2012A or MOA-6000 manufactured by Oji Scientific Instruments, at a resonance frequency around 4 GHz or 12 GHz.

As described above, a polymeric piezoelectric film of the present embodiment preferably has the standardized molecular orientation MORc of from 3.5 to 15.0.

When the standardized molecular orientation MORc is 3.5 or more, the number of molecular chains of the molecularly orientated helical chiral polymer (A) in the polymeric piezoelectric film is large, and as the result, a high piezoelectricity of the polymeric piezoelectric film is maintained.

When the standardized molecular orientation MORc is 15.0 or less, a decrease in transparency due to an excessively large amount of molecular chains of a molecularly orientated helical chiral polymer (A) is suppressed, and as the result, a high transparency of the polymeric piezoelectric film is maintained.

The standardized molecular orientation MORc is more preferably from 3.5 to 10.0 and still more preferably from 4.0 to 8.0.

When the polymeric piezoelectric film is, for example, a stretched film, the standardized molecular orientation MORc can be controlled by heat treatment conditions (heating temperature and heating time) before stretching, stretching conditions (stretching temperature and stretching speed), or the like.

The standardized molecular orientation MORc can be converted to birefringence Δn which is obtained by dividing retardation by a film thickness. Specifically, the retardation can be measured by a RETS100 manufactured by Otsuka Electronics Co., Ltd. MORc and Δn are approximately in a linearly proportional relationship. When Δn is 0, MORc is 1.

For example, when the helical chiral polymer (A) is a polylactic acid polymer and the birefringence Δn of the polymeric piezoelectric film is measured at measurement wavelength of 550 nm, the lower limit 2.0 of a preferable range for the standardized molecular orientation MORc can be converted to the birefringence Δn of 0.005. The lower limit 40 of a preferable range of a product of the crystallinity and the standardized molecular orientation MORc of the polymeric piezoelectric film which will be mentioned below can be converted to 0.1 as a product of the birefringence Δn and the crystallinity of the polymeric piezoelectric film.

< Crystallinity >

In the present embodiment, the crystallinity of a polymeric piezoelectric film is determined by a DSC method.

As described above, the crystallinity of the polymeric piezoelectric film of the present embodiment is from 20% to 80%.

When the crystallinity is 20% or more, the piezoelectricity of the polymeric piezoelectric film is maintained high.

When the crystallinity is 80% or less, the transparency of the polymeric piezoelectric film is maintained high; and when the crystallinity is 80% or less, since whitening or a break is less likely to occur during stretching, the polymeric piezoelectric film can be manufactured easily.

Therefore, the crystallinity of the polymeric piezoelectric film is preferably from 20% to 80%, more preferably from 25% to 70%, and still more preferably from 30% to 50%.

< Product of Crystallinity and Standardized Molecular Orientation MORc >

As described above, the product of the crystallinity and the standardized molecular orientation MORc of a polymeric piezoelectric film is from 25 to 700. When the above-described product is within a range from 25 to 700, a balance between the piezoelectricity and the transparency of the polymeric piezoelectric film is favorable and the dimensional stability is high, and therefore, the polymeric piezoelectric film can be suitably used for a piezoelectric element described below.

The product of the crystallinity and the standardized molecular orientation MORc of a polymeric piezoelectric film is preferably from 40 to 700, more preferably from 75 to 680, further preferably from 90 to 660, still more preferably from 125 to 650, and particularly preferably from 150 to 350.

It is possible to adjust the product within the above range, for example, by adjusting the conditions of crystallization and stretching when the polymeric piezoelectric film is manufactured.

The thickness of a polymeric piezoelectric film of the present embodiment is not particularly restricted, and is preferably from 10 μm to 400 μm, more preferably from 20 μm to 200 μm, further preferably from 20 μm to 100 μm, and particularly preferably from 20 μm to 80 μm.

< Optically Active Helical Chiral Polymer (Optically Active Polymer) >

A polymeric piezoelectric film according to the present embodiment contains an optically active helical chiral polymer (hereinafter, also referred to as "optically active polymer").

Here, an optically active helical chiral polymer (optically active polymer) refers to an optically active polymer whose molecular structure is a helical structure.

Examples of an optically active polymer include polypeptide, cellulose derivatives, polylactic acid polymer, polypropylene oxide, or poly($\beta$-hydroxy butyric acid).

Examples of the polypeptides include poly(glutaric acid $\gamma$-benzyl) or poly(glutaric acid $\gamma$-methyl).

Examples of the cellulose derivatives include acetic acid cellulose or cyano ethyl cellulose.

The optical purity of the optically active polymer is preferably 95.00%ee or more, more preferably 96.00%ee or more, still more preferably 99.00%ee or more, and still further preferably 99.99%ee or more. Desirably, the optical purity is 100.00%ee.

When the optical purity of an optically active polymer is within the above range, a packing property of a polymer crystal in the polymeric piezoelectric film is high. As a result, the piezoelectricity (piezoelectric constant) of the polymeric piezoelectric film can be more improved.

The optical purity of the above-described optically active polymer is a value calculated by the following formula.

$$\text{Optical purity (\%ee)} = 100 \times |\text{L-form amount} - \text{D-form amount}| / (\text{L-form amount} + \text{D-form amount})$$

That is, a value obtained by multiplying (multiplying) "’the value obtained by dividing (dividing) "the amount difference (absolute value) between the amount [% by mass] of optically active polymer in L-form and the amount [% by mass] of optically active polymer in D-form" by "the total amount of the amount [% by mass] of optically active polymer in L-form and the amount [% by mass] of optically active polymer in D-form"’ by ’100’ is defined as the optical purity.

For the amount [% by mass] of optically active polymer in L-form and the amount [% by mass] of optically active polymer in D-form, values obtained by a method using a high performance liquid chromatography (HPLC) are used.

For the above optically active polymer, a polymer having a main chain including a repeating unit represented by the following Formula (1) is preferable from a viewpoint of increasing the optical purity (and from a viewpoint of improving the piezoelectricity when the film is used as a piezoelectric film).

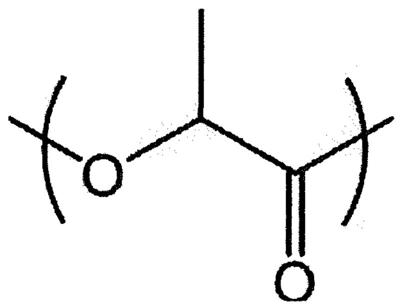

(1)

Examples of the polymer having a main chain including a repeating unit represented by the Formula (1) include a polylactic acid polymer. Among others, a polylactic acid is preferable, and a homopolymer (PLLA) of an L-lactic acid or a homopolymer (PDLA) of a D-lactic acid is the most preferable. The polylactic acid polymer in the present embodiment refers to "polylactic acid (a polymer compound consisting only of a repeating unit derived from a monomer selected from L-lactic acid or D-lactic acid)", "a copolymer of L-lactic acid or D-lactic acid and a compound copolymerizable with the L-lactic acid or D-lactic acid", or a mixture thereof.

The "polylactic acid" is a long polymer which is obtained by polymerizing lactic acid by ester bond to be connected with each other, and is known to be manufactured by: a lactide method involving lactide; a direct polymerization method in which lactic acid is heated in a solvent under a reduced pressure to be polymerized while removing water; or the like. Examples of the "polylactic acid" include a homopolymer of L-lactic acid, a homopolymer of D-lactic acid, a block copolymer including a polymer of at least one of L-lactic acid or D-lactic acid, or a graft copolymer including a polymer of at least one of L-lactic acid or D-lactic acid.

Examples of the "compound copolymerizable with an L-lactic acid or a D-lactic acid" include: a hydroxy carboxylic acid such as glycolic acid, dimethyl glycolic acid, 3-hydroxy butyric acid, 4-hydroxy butyric acid, 2-hydroxy propanoic acid, 3-hydroxy propanoic acid, 2-hydroxy valeric acid, 3-hydroxy valeric acid, 4-hydroxy valeric acid, 5-hydroxy valeric acid, 2-hydroxy caproic acid, 3-hydroxy caproic acid, 4-hydroxy caproic acid, 5-hydroxy caproic acid, 6-hydroxy caproic acid, 6-hydroxymethyl caproic acid, or mandelic acid; a cyclic ester such as glycolide, $\beta$-methyl-$\delta$-valerolactone, $\gamma$-valerolactone, or $\varepsilon$-caprolactone; a polycarboxylic acid such as oxalic acid, malonic acid, succinic acid, glutaric acid, adipic acid, pimelic acid, azelaic acid, sebacic acid, undecanedioic acid, dodecane diacid, or terephthalic acid, or an anhydride of such a polycarboxylic acid; a polyalcohol such as ethylene glycol, diethylene glycol, triethylene glycol, 1,2-propane diol, 1,3-propanediol, 1,3-butanediol, 1,4-butanediol, 2,3-butanediol, 1,5-pentane diol, 1,6-hexane diol, 1,9-nonane diol, 3-methyl-1,5-pentane diol, neopentyl glycol, tetramethylene glycol, or 1,4-hexane dimethanol; a polysaccharide such as cellulose; or an aminocarboxylic acid such as $\alpha$-amino acid.

Examples of the "copolymer of one of L-lactic acid and D-lactic acid and a compound copolymerizable with the L-lactic acid or the D-lactic acid" include a block copolymer or a graft copolymer having a polylactic acid sequence which can form a helical crystal.

The concentration of a structure derived from a copolymer component in an optically active polymer is preferably 20 mol% or less. For example, when the optically active polymer is a polylactic acid polymer, with respect to the total number of moles of a structure derived from lactic acid and a structure derived from a compound copolymerizable with lactic acid (copolymer component) in the optically active polymer, the copolymer component is preferably 20 mol% or less.

The polylactic acid-type polymer can be manufactured, for example, by a method of obtaining the polymer by direct dehydration condensation of lactic acid, described in JP-A No. S59-096123 and JP-A No. H7-033861, or a method of obtaining the polymer by a ring-opening polymerization of lactide which is a cyclic dimer of lactic acid, described in U.S. Patents Nos. 2,668,182 and 4,057,357, or the like.

In order to make the polymer obtained by any of the above manufacturing methods 95.00%ee or more, for example, when a polylactic acid is manufactured by a lactide method, it is preferable to polymerize lactide the optical purity of which has been enhanced to 95.00%ee or more by a crystallization operation.

For the polylactic acid-type polymer, a commercially available polylactic acid may be used, and examples thereof include PURASORB (PD, PL) manufactured by Purac Inc., LACEA (H-100, H-400) manufactured by Mitsui Chemicals, Inc., and Ingeo™ biopolymer manufactured by NatureWorks LLC.

When a polylactic acid-type polymer is used as the optically active polymer, it is preferable to manufacture the optically active polymer by a lactide method or a direct polymerization method in order to make the weight average molecular weight (Mw) of the polylactic acid-type polymer 50,000 or more.

The content of the optically active polymer in the polymeric piezoelectric film of the present embodiment is preferably 80% by mass or more with respect to the total amount of the polymeric piezoelectric film.

The weight average molecular weight of the optically active polymer is preferably from 50,000 to 1,000,000.

When the weight average molecular weight of the optically active polymer is 50,000 or more, the mechanical

strength of the film is more improved. The weight average molecular weight of the optically active polymer is preferably 100,000 or more, and further preferably 150,000 or more.

On the other hand, when the weight average molecular weight of the optically active polymer is 1,000,000 or less, it is difficult to form (for example, by extrusion) the optically active polymer into a film shape. The weight average molecular weight of the optically active polymer is preferably 800,000 or less, and further preferably 300,000 or less.

From the viewpoint of the strength of the film, the molecular weight distribution (Mw/Mn) of the optically active polymer is preferably from 1.1 to 5, more preferably from 1.2 to 4, and further preferably from 1.4 to 3.

The weight average molecular weight Mw and the molecular weight distribution (Mw/Mn) of the optically active polymer are measured by the following GPC measurement method using gel permeation chromatography (GPC).

- GPC Measure Apparatus -

Manufactured by Waters Corp., GPC-100

- Column -

Manufactured by Showa Denko K.K., Shodex LF-804

- Preparation of Sample -

The optically active polymer is dissolved in a solvent (for example, chloroform) at 40°C to prepare a sample solution having a concentration of 1 mg/mL.

- Measurement Condition -

0.1 mL of the sample solution is introduced into a column at a temperature of 40°C and a flow rate of 1 mL/min by using chloroform as a solvent.

The sample concentration in the sample solution separated by the column is measured by a differential refractometer. A universal calibration curve is created based on a polystyrene standard sample. The weight average molecular weight (Mw) and the molecular weight distribution (Mw/Mn) of the optically active polymer are calculated.

< Internal Haze >

Transparency of the polymeric piezoelectric film according to the present embodiment can be evaluated, for example, by visual observation or measurement of haze.

An internal haze for visible light (hereinafter, also simply referred to as "internal haze") of the polymeric piezoelectric film of the present embodiment is preferably 40% or less, more preferably 20% or less, still more preferably 10% or less, still more preferably 5% or less, particularly preferably 2% or less, and most preferably 1% or less.

The lower the internal haze of the polymeric piezoelectric film is, the better the polymeric piezoelectric film is. From a viewpoint of the balance with the piezoelectric constant, *etc.* the internal haze is preferably from 0.01% to 15%, further preferably from 0.01% to 10%, and particularly preferably from 0.1 % to 5%.

In the present embodiment, the "internal haze" refers to a haze from which a haze caused by the shape of an external surface of the polymeric piezoelectric film is excluded.

The "internal haze" herein refers to a value measured with respect to a polymeric piezoelectric film at 25°C in accordance with JIS-K7105.

More specifically, the internal haze (hereinafter, also referred to as "internal haze H1") refers to a value measured as follows.

That is, first, for a cell having an optical path length of 10 mm filled with a silicone oil, a haze (hereinafter, also referred to as "haze H2") in the optical path length direction was measured. Next, a polymeric piezoelectric film of the present embodiment is immersed in the silicone oil of the cell such that the optical path length direction of the cell is in parallel with the normal direction of the film, and a haze (hereinafter, also referred to as "haze H3 ") in the optical path length direction of a cell in which the polymeric piezoelectric film is immersed. The haze H2 and the haze H3 are both measured at 25°C in accordance with JIS-K7105.

An internal haze H1 is determined in accordance with the following formula based on the measured haze H2 and haze H3.

$$\text{Internal haze (H1)} = \text{Haze (H3)} - \text{Haze (H2)}$$

Measurement of the haze H2 and the haze H3 can be performed by using, for example, a haze measuring machine [TC-HIII DPK manufactured by Tokyo Denshoku Co., Ltd.,].

For the silicone oil, for example, "Shin-Etsu Silicone (trade mark), model number: KF-96-100CS" manufactured by Shin-Etsu Chemical Co., Ltd. can be used.

< Internal Haze of OCA Stuck Product >

In the present embodiment, an "internal haze of OCA stuck product" refers to a haze from which a haze caused by the shape of an external surface of an OCA stuck product composed of five layers, an optical PET film, an OCA, a polymeric piezoelectric film, an OCA, and an optical PET film formed by sticking OCAs on two principal planes of a polymeric piezoelectric film is excluded.

Here, the term "principal plane" refers to a plane having the largest area among the surfaces of the polymeric piezoelectric film. The polymeric piezoelectric film of the present embodiment may have two or more principal planes. For example, when the polymeric piezoelectric film is a plate body having two plates A with a size of length 10 mm × width 0.3 mm, two plates B with a size of length 3 mm × width 0.3 mm, and two plates C with a size of length 10 mm × width 3 mm, the principal plane of the polymeric piezoelectric film is the plate C, and the plate body has two principal planes.

In an OCA stuck product of the present embodiment, the internal haze of the OCA stuck product with respect to a visible light is preferably 40% or less, more preferably 20% or less, further preferably 10% or less, further preferably 5% or less, and particularly preferably 2% or less, and most preferably 1% or less.

The lower the internal haze of an OCA stuck product is, the better the internal haze of an OCA stuck product is, and from the viewpoint of the balance with a piezoelectric constant or the like, the internal haze of an OCA stuck product is preferably from 0.1 % to 10%, more preferably from 0.3% to 5%, further preferably from 0.4% to 3%, and particularly preferably from 0.5% to 2%.

The internal haze of an OCA stuck product may be measured in a similar method to the method of measuring the internal haze of a polymeric piezoelectric film.

< Piezoelectric Constant $d_{14}$ (Stress-electric Charge Method) >

The piezoelectricity of a polymeric piezoelectric film can be evaluated by, for example, measuring the piezoelectric constant $d_{14}$ of the polymeric piezoelectric film.

In the following, one example of a method of measuring the piezoelectric constant $d_{14}$ by a stress-electric charge method will be described.

First, a polymeric piezoelectric film is cut to a length of 150 mm in the direction of 45° with respect to the stretching direction (MD direction), and to 50 mm in the direction perpendicular to the above 45° direction, to prepare a rectangular specimen.

Subsequently, the prepared specimen is set on a stage of Showa Shinku SIP-600, and aluminum (hereinafter, referred to as "Al") is deposited on one surface of the specimen such that the deposition thickness of Al becomes about 50 nm.

Subsequently, Al is deposited on the other surface of the specimen similarly. Both surfaces of the specimen are covered with Al to form conductive layers of Al.

The specimen of 150 mm×50 mm having the Al conductive layers formed on both surfaces is cut to a length of 120 mm in the direction of 45° with respect to the stretching direction (MD direction) of the polymeric piezoelectric film, and to 10 mm in the direction perpendicular to the above 45° direction, to cut out a rectangular film of 120 mm×10 mm. This film is used as a sample for measuring a piezoelectric constant.

The sample thus obtained is set in a tensile testing machine (TENSILON RTG-1250 manufactured by A&D Company, Limited) having a distance between chucks, of 70 mm so as not to be slack. A force is applied periodically at a crosshead speed of 5 mm/min such that the applied force reciprocates between 4 N and 9 N. In order to measure a charge amount generated in the sample according to the applied force at this time, a capacitor having an electrostatic capacity Qm (F) is connected in parallel to the sample, and a voltage V between the terminals of this capacitor Cm (95 nF) is measured through a buffer amplifier. The above measurement is performed under a temperature condition of 25°C. A generated charge amount Q (C) is calculated as a product of the capacitor capacity Cm and a voltage Vm between the terminals. The piezoelectric constant $d_{14}$ is calculated by the following formula.

$$d_{14} = (2 \times t)/L \times Cm \bullet \Delta Vm/\Delta F$$

t: sample thickness (m)
L: distance between chucks (m)
Cm: capacity (F) of capacitor connected in parallel
$\Delta$Vm/$\Delta$F: ratio of change amount of voltage between terminals of capacitor with respect to change amount of force

A higher piezoelectric constant $d_{14}$ results in a larger displacement of the polymeric piezoelectric film with respect to a voltage applied to the polymeric piezoelectric film, and reversely a higher voltage generated responding to a force applied to the polymeric piezoelectric film, and therefore is advantageous as a polymeric piezoelectric film.
Specifically, in the polymeric piezoelectric film according to the invention, the piezoelectric constant $d_{14}$ measured at 25°C by a stress-charge method is 1 pC/N or more, preferably 3 pC/N or more, and more preferably 4 pC/N or more. The upper limit of the piezoelectric constant $d_{14}$ is not particularly limited, and is preferably 50 pC/N or less, and more preferably 30 pC/N or less, for a polymeric piezoelectric film using a helical chiral polymer from a viewpoint of a balance with transparency, or the like described below.
Similarly, from a viewpoint of the balance with transparency, the piezoelectric constant $d_{14}$ measured by a resonance method is preferably 15 pC/N or less.
Herein, the "MD direction" refers to a direction (Machine Direction) in which a film flows.
From the viewpoint of effectively attaining a balance between the transparency and the piezoelectricity of the polymeric piezoelectric film of the present embodiment, it is particularly preferable that an internal haze for visible light is 40% or less and a piezoelectric constant $d_{14}$ measured by a stress-electric charge method at 25°C is 1 pC/N or more.

< Stabilizer >

A polymeric piezoelectric film according to the present embodiment preferably contains, as a stabilizer, a compound which has one or more functional groups selected from the group consisting of a carbodiimide group, an epoxy group, and an isocyanate group and whose weight average molecular weight is from 200 to 60,000.
By this, a hydrolysis reaction of an optically active polymer (helical chiral polymer) is suppressed, thereby further improving the moist heat resistance of a film to be obtained.
Regarding a stabilizer, description in paragraphs 0039 to 0055 of WO 2013/054918 can be appropriately referred to.

< Antioxidant >

A polymeric piezoelectric film according to the present embodiment may contain an antioxidant. The antioxidant is at least one selected from the group consisting of a hindered phenol-based compound, a hindered amine-based compound, a phosphite-based compound, and a thioether-based compound.
For the antioxidant, a hindered phenol-based compound or a hindered amine-based compound is preferably used. By this, a polymeric piezoelectric film having excellent moist heat resistance and transparency can be provided.

< Other Components >

A polymeric piezoelectric film according to the present embodiment may contain other components, for example, known resins represented by polyvinylidene fluoride, a polyethylene resin, and a polystyrene resin; an inorganic filler such as silica, hydroxy apatite, montmorillonite; or known nucleating agents such as phthalocyanine, as long as effects of the invention are not compromised.
Regarding other components such as an inorganic filler and a nucleating agent, description of paragraphs 0057 to 0060 of WO 2013/054918 can be appropriately referred to.
When the polymeric piezoelectric film contains a component other than helical chiral polymer (A), the content of the component other than the helical chiral polymer (A) is preferably 20% by mass or less, and more preferably 10% by mass or less with respect to the total mass of the polymeric piezoelectric film.
From the viewpoint of transparency, the polymeric piezoelectric film preferably does not contain a component other than the helical chiral polymer (A).

[Method of Manufacturing Polymeric piezoelectric Film]

A method of manufacturing a polymeric piezoelectric film according to the present embodiment is not particularly restricted. A polymeric piezoelectric film according to the present embodiment can be manufactured, for example, by a manufacturing method comprising a first step of obtaining a pre-crystallized film (also referred to as a crystallized original sheet) by crystallizing an amorphous state sheet containing a helical chiral polymer (A) and the above-described stabilizer, a second step of stretching the pre-crystallized film mainly in a uniaxial direction(, and a step of performing an annealing treatment, is necessary). Examples of such a method of manufacturing a polymeric piezoelectric film include a manufacturing method described in paragraphs 0065 to 0099 of WO 2013/054918.
The non-contact three-dimensional surface roughness Sa can be controlled by a cooling condition when a polymeric piezoelectric film is manufactured. In general, when a cooling temperature is high, a film is likely to be affected by the surface roughness of a member in contact with during cooling. Being likely to be affected by the surface roughness refers to tendencies that, when the surface roughness of a member in contact with is high, the surface roughness of a polymeric piezoelectric film tends to be high, and when the surface roughness of a member in contact with is low, the surface roughness of the polymeric piezoelectric film tends to be low.
The non-contact three-dimensional surface roughness Sa can be controlled by heat treatment conditions (for example, heating method, heating temperature, heating time, surface roughness of a member in contact with during heating) before stretching (preheating) and/or after stretching (annealing). Examples of a heating method include roll heating optical heating such as IR heating or hot air heating in a furnace. In general, while, in roll heating, a film is likely to be affected by the surface roughness of a roll, in optical heating or hot air heating in a furnace, a film is less likely to be affected by the surface roughness of a roll before and after heating even by roll-to-roll, and the surface roughness tends to be low.
The non-contact three-dimensional surface roughness Sa can also be controlled by a surface treatment to a polymeric piezoelectric film. Examples of a surface treatment to a polymeric piezoelectric film include a roughening treatment or a smoothing treatment. Examples of a roughening treatment include a sandblast treatment, an etching treatment by a liquid which dissolves or swells the surface of a polymeric piezoelectric film, or a treatment of contacting a polymeric piezoelectric film with a member having a high surface roughness at a temperature which is a glass transition temperature of the polymeric piezoelectric film or more. Examples of a smoothing treatment include a grinding treatment, a treatment of contacting a polymeric piezoelectric film with a member having a low surface roughness at a temperature which is a glass transition temperature of the polymeric piezoelectric film or more, or a treatment of forming a coating layer on a polymeric piezoelectric film.
A coating layer refers to a layer which exists on the surface of a polymeric piezoelectric film and at least a part of which is in contact with the polymeric piezoelectric film. The material of the coating layer is not particularly limited, and examples thereof include an acrylic compound, a methacrylic compound, a vinyl compound, an allyl compound, a urethane compound, an epoxy compound, an epoxide compound, a glycidyl compound, an oxetane compound, a melamine compound, a cellulose compound, an ester compound, a silane compound, a silicone compound, a siloxane compound, a silica-acryl hybrid compound, a silica-epoxy hybrid compound, a metal, and a metal oxide. Among these, an acrylic compound, an epoxy compound, a silane compound, or a metal oxide is more preferable. As a method of forming a coating layer, it is possible to use a publicly known method which has been conventionally and generally used, if appropriate. Examples thereof include a wet coating method.
A coating layer is formed by applying a coating liquid in which the material as illustrated as a material of the coating layer is dispersed or dissolved and, if necessary, by drying and removing an unnecessary solvent.
Furthermore, if necessary, the coating layer is cured by irradiating the material with heat or an active energy ray (an ultraviolet ray, an electron beam, radiation, or the like). When the coating layer contains a cured product of a curable compound, by reducing the equivalent amount of a polymerizable functional group of the curable compound (that is, by increasing the number of polymerizable functional groups contained in unit molecular weight of the curable compound), the crosslinking density is increased. As a material contained in the coating layer, a cured product having a three-dimensional crosslinked structure is preferable among the above-described cured products. A coating layer having such a three-dimensional crosslinked structure preferably contains a (meth)acrylic compound having three or more (meth)acrylic groups in one molecule thereof.

[Uses of Polymeric piezoelectric Film or the Like]

A polymeric piezoelectric film of the present embodiment can be suitably used for, for example, a piezoelectric film.
A polymeric piezoelectric film of the present embodiment can also be used as an optical film or the like which is used for a display apparatus or the like other than a piezoelectric film.
A polymeric piezoelectric film of the present embodiment can be used in various fields including a speaker, a

headphone, a touch panel, a remote controller, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, an acoustic equipment, an information processing equipment, a measurement equipment, and a medical appliance.

A polymeric piezoelectric film of the present embodiment is preferably used as a piezoelectric element which has at least two principal planes on which an electrode is provided.

The electrode may be provided on at least two planes of the polymeric piezoelectric film. A pressure-sensitive adhesive layer or a substrate layer may be provided between an electrode and the polymeric piezoelectric film. The electrode is not particularly limited, and examples thereof include ITO, ZnO, IGZO, and a conductive polymer.

The polymeric piezoelectric film can be used as a layered piezoelectric element by repeatedly stacking the film and an electrode. For example, a unit of an electrode and a polymeric piezoelectric film is repeatedly stacked on another unit, and a principal plane of the polymeric piezoelectric film which is not covered with an electrode is finally covered with an electrode to form a layered piezoelectric element. Specifically, a layered piezoelectric element having two repeating units is a layered piezoelectric element formed by stacking an electrode, a polymeric piezoelectric film, an electrode, a polymeric piezoelectric film, and an electrode, in the order mentioned. At least one polymeric piezoelectric film which is used for a layered piezoelectric element is a polymeric piezoelectric film according to the present embodiment, and other layers may be not a polymeric piezoelectric film according to the present embodiment.

When a layered piezoelectric element contains a plurality of polymeric piezoelectric films, if the optical activity of a helical chiral polymer (A) contained in a polymeric piezoelectric film of a certain layer is L-form, the helical chiral polymer (A) contained in a polymeric piezoelectric film of other layers may be L-form or D-form. Arrangement of a polymeric piezoelectric film can be appropriately adjusted according to a use of a piezoelectric element.

For example, when a first layer of a polymeric piezoelectric film containing a helical chiral polymer (A) in L-form as a main component is stacked with a second layer of a polymeric piezoelectric film containing a helical chiral polymer (A) in L-form as a main component via an electrode, it is preferable to cross the uniaxial stretching direction (the main stretching direction) of the first polymeric piezoelectric film with the uniaxial stretching direction (the main stretching direction) of the second polymeric piezoelectric film, preferably perpendicular to each other, since directions of displacements of the first polymeric piezoelectric film and the second polymeric piezoelectric film can be made uniform, thereby increasing the piezoelectricity of the layered piezoelectric element as a whole.

On the other hand, when a first layer of a polymeric piezoelectric film containing a helical chiral polymer (A) in L-form as a main component is stacked with a second layer of a polymeric piezoelectric film containing a helical chiral polymer (A) in D-form as a main component via an electrode, it is preferable to arrange the uniaxial stretching direction (the main stretching direction) of the first polymeric piezoelectric film substantially in parallel with the uniaxial stretching direction (the main stretching direction) of the second polymeric piezoelectric film, since directions of displacements of the first polymeric piezoelectric film and the second polymeric piezoelectric film can be made uniform, thereby increasing the piezoelectricity of the layered piezoelectric element as a whole.

Particularly when an electrode is provided on the principal plane of a polymeric piezoelectric film, a transparent electrode is preferably provided. Here, a transparent electrode specifically means that its internal haze is 20% or less (total luminous transmittance is 80% or more).

The piezoelectric element using a polymeric piezoelectric film according to the present embodiment may be applied to the above various piezoelectric devices including a speaker a touch panel and a pressure sensor. Particularly, a piezoelectric element including a transparent electrode is suitable for application to a speaker, a touch panel, a pressure sensor, an actuator, or the like.

[Examples]

Hereinafter, embodiment of the invention will be described more specifically by way of Examples. The present embodiment is not limited to the following Examples as long as the present embodiment departs from the gist of the invention. The surface roughness Ra refers to an arithmetic mean roughness defined in JIS-B-0601 (2001).

[Example 1]

< Manufacturing Polymeric piezoelectric Film >

A polylactic acid (PLA) (trade name: Ingeo™ biopolymer, brand name: 4032D, weight average molecular weight Mw: 200,000) manufactured by NatureWorks LLC as a helical chiral polymer was placed in a hopper of an extrusion molding machine, extruded from a T-die having a width of 2,000 mm while being heated at from 220°C to 230°C, and

brought into contact with a cast roll (surface roughness Ra = 0.05 μm) at 50°C for 0.5 minutes to form a pre-crystallized film having a thickness of 150 μm (molding step).

Stretching of the obtained pre-crystallized film was started at a stretching speed of 1,650 mm/min by roll-to-roll while the film was heated by being in contact with a roll heated at 70°C, and the film was stretched up to 3.5-fold uniaxially in the MD direction to obtain a uniaxially stretched film (stretching step).

Thereafter, the uniaxially stretched film was brought into contact with a roll (surface roughness Ra = 0.2 μm) heated to 130°C by roll-to-roll for 78 seconds, and then quenched by a roll which is set to 50°C. The quenched film was slit to cut both end portions thereof evenly in the film width direction to obtain a film having a width of 1,500mm. The film was further wound into a roll shape to obtain a film-shaped polymeric piezoelectric film (annealing step).

The thickness of the obtained polymeric piezoelectric film was 50 μm. In the present Example, a surface which a roll (surface roughness Ra = 0.2 μm) was in contact with was used as a measuring surface for the non-contact three-dimensional surface roughness Sa.

(Weight Average Molecular Weight and Molecular Weight Distribution of Helical Chiral Polymer)

By using gel permeation chromatograph (GPC), the weight average molecular weight (Mw) and molecular weight distribution (Mw/Mn) of a helical chiral polymer (polylactic acid) contained in the polymeric piezoelectric film was measured by the following GPC measurement method.

As the result, Mw was 200,000, and Mw/Mn was 1.9.

- GPC Measurement Method -

• Measurement Apparatus

GPC-100 manufactured by Waters Corp.

• Column

Shodex LF-804 manufactured by Showa Denko K.K.

• Preparation of Sample Solution

The above polymeric piezoelectric film was dissolved in a solvent [chloroform] to prepare a sample solution having a concentration of 1 mg/mL.

• Measurement Condition

0.1 mL of a sample solution was introduced into a column, using a solvent (chloroform), at a temperature of 40°C, and at a flow rate of 1 mL/min, and the sample concentration in the sample solution separated in the column was measured by a differential refractometer. The weight average molecular weight (Mw) of polylactic acid was calculated using a universal calibration curve created based on a polystyrene standard sample.

(Optical Purity of Helical Chiral Polymer)

The optical purity of a helical chiral polymer (polylactic acid) contained in the above-described polymeric piezoelectric film was measured in the following manner.

First, 1.0 g of a sample (the above-described polymeric piezoelectric film) was measured and placed into a 50 mL-conical flask, and 2.5 mL of IPA (isopropyl alcohol) and 5 mL of 5.0 mol/L sodium hydroxide solution were added the flask to prepare a sample solution.

Next, the conical flask containing the sample solution was placed in a water bath having a temperature of 40°C, and the sample solution was stirred for about 5 hours until the polylactic acid was completely hydrolyzed.

The sample solution after being stirred for about 5 hours was cooled to room temperature, and then, 20 mL of 1.0 mol/L hydrochloric acid solution was added thereto to be neutralized, followed by stirring with the conical flask tightly sealed.

Next, 1.0 mL of the sample solution stirred above was put in a 25 mL-measuring flask, and a mobile phase of the following composition was added thereto, to obtain 25 mL of an HPLC sample solution 1.

Five μL of the obtained HPLC sample solution 1 was poured into an HPLC apparatus, and HPLC measurement was performed by the following HPLC measurement conditions. From the obtained measurement result, an area of a

peak derived from polylactic acid in D-form and an area of a peak derived from polylactic acid in L-form were determined to calculate the L-form amount and the D-form amount.

Based on the obtained result, the optical purity (%ee) was determined.

As the result, the optical purity was 97.0%ee.

- HPLC Measurement Condition -

• Column

Optical resolution column, SUMICHIRAL OA5000 manufactured by Sumika Chemical Analysis Service, Ltd.

• HPLC apparatus

Liquid chromatography manufactured by JASCO Corporation

• Column Temperature

25°C

• Composition of Mobile Phase

$$1.0\ \text{mM- copper sulfate (II) buffer solution /IPA} = 98/2(\text{V/V})$$

(In this mobile phase, the ratio of copper sulfate (II), IPA, and water is copper sulfate (II) /IPA /water = 156.4 mg /20 mL /980 mL.)

• Mobile phase flow rate

1.0 mL/min

• Detector

Ultraviolet detector (UV254 nm)

(Internal Haze of Separate Film)

An internal haze (H1) of the above-described polymeric piezoelectric film (separate film) was measured by the following method.

First, a layered body which was obtained by sandwiching only a silicone oil (SHIN-ETSU SILICONE (trade mark), model number: KF96-100CS manufactured by Shin-Etsu Chemical Co., Ltd.) between two glass plates was prepared, and a haze (hereinafter, referred to as "haze (H2)") of the layered body in the thickness direction was measured.

Next, a layered body which was obtained by sandwiching a polymeric piezoelectric film on the surface of which a silicone oil was uniformly applied between the two glass plates was prepared, and a haze (hereinafter, referred to as "haze (H3)") of the layered body in the thickness direction was measured.

Next, the internal haze (H1) of the polymeric piezoelectric film was obtained by calculating the difference between the two values according to the following formula.

$$\text{Internal haze (H1)} = \text{haze (H3)} - \text{haze (H2)}$$

Here, measurements of the haze (H2) and the haze (H3) were each performed by using the following apparatus under the following measurement condition.

Measurement apparatus: HAZE METER TC-HIII DPK manufactured by Tokyo Denshoku Co., LTD.
Sample size: width 300 mm × length 30 mm
Measurement condition: In accordance with JIS-K7105
Measurement temperature: Room temperature (25°C)

(Standardized Molecular Orientation MORc)

By using a microwave molecular orientation meter MOA-6000 manufactured by Oji Scientific Instruments, the standardized molecular orientation MORc of the above polymeric piezoelectric film was measured. The reference thickness tc was set to 50 μm.

(Crystallinity)

10 mg of the above-described piezoelectric material was accurately weighed, and for the 10 mg of weighed piezoelectric material, measurement was performed by using a differential scanning calorimetry (DSC -1 manufactured by Perkin Elmer Co., Ltd.) at a temperature rising rate of 10°C/min to obtain a melting endothermic curve. From the obtained melting endothermic curve, the crystallinity was obtained.

(Piezoelectric Constant $d_{14}$)

The piezoelectric constant $d_{14}$ of the polymeric piezoelectric film was measured according to one example of a method of measuring the piezoelectric constant $d_{14}$ by the stress-charge method (25°C) as described above.

(Non-contact Three-dimensional Surface Roughness)

The non-contact three-dimensional surface roughness Sa of the above-described polymeric piezoelectric film was measured by the following method.

Platinum was sputtered on a measuring surface of a polymeric piezoelectric film of the present embodiment by using a sputtering apparatus (J-1000 manufactured by ULVAC, Inc.), and then, a non-contact three-dimensional surface roughness Sa was calculated in accordance with ISO 25178 from the result of image analysis in an area of 645 μm × 644 μm by using a confocal laser microscope (LEXT OLS 4000 manufactured by Olympus Corporation, objective lens ×20). Specifically, this measurement was performed on three points in the measuring surface of the film, and the measured values were averaged to obtain a non-contact three-dimensional surface roughness Sa.

(Charged Voltage)

Two 100 mm square films were cut out from a roll-shaped polymeric piezoelectric film, electric charges on the surface of the films were cancelled by IONIZER MODEL 10/10 manufactured by Hugle Electronics Inc., and then the two films were laminated in such a way that the frontside (a measuring surface of the Sa) and the backside of the two films were in contact with each other to be press-bonded by a 2 kg-load roll in a constant direction for ten times. Then, the two press-bonded films were peeled from each other under an atmosphere at 20°C × 40%RH at a rate of 10 m/min, and a charged voltage (kV) of the film was measured with DIGITAL STATIC METER KSD-1000 manufactured by KASUGA ELECTRIC WORKS LTD.

< Manufacturing OCA stuck product >

Next, on two principal planes of the polymeric piezoelectric film as manufactured above, OCAs (Optical Clear Adhesive) (brand name: 5402A-50) manufactured by Sekisui Chemical Co., Ltd. were stuck by a 2 kg roll. A mold releasing film of the OCA disposed on the opposite to the polymeric piezoelectric film was peeled, and an optical PET film (LUMIRROR U34#50 manufactured by Toray Industries, Inc.) was stuck by a 2 kg roll. By this, an OCA stuck product composed of five layers, an optical PET film, an OCA, a polymeric piezoelectric film, an OCA, and an optical PET film was obtained.

(Internal haze of OCA stuck product)

An internal haze (H1) of the above-described OCA stuck product was measured in a similar method to the above-described method of measuring the internal haze of a separate film.

(Appearance After Sticking Together)

Next, the appearance when an OCA was stuck was evaluated by visual inspection. The evaluation criteria are as follows.

A: No visible air inclusion was observed, no distortion of transmission light was observed, and the appearance is favorable.
B: Although no visible air inclusion was observed and a transmission light was slightly distorted, there was no problem in the appearance.
C: Visible air inclusions were scattered, and in addition, a transmission light was largely distorted, and there was a large problem in the appearance.

[Example 2]

A polymeric piezoelectric film was manufactured in a similar manner to Example 1 except that the cast roll was change to a cast roll having the surface roughness Ra = 0.1 1 μm in the molding step.
The same measurement and evaluation as in Example 1 were performed on the obtained polymeric piezoelectric film and an OCA stuck product manufactured from the film in a similar manner to Example 1.

[Example 3]

On a principal plane of the polymeric piezoelectric film manufactured in Example 1, an acrylic resin coating liquid (anti-block hard coat LIODURAS TYAB-014 manufactured by TOYO INK CO., LTD.) was coated by roll-to-roll, dried in a heating furnace at 80°C, irradiated with ultraviolet rays at an accumulated light amount of 500 $mJ/cm^2$ to form a hard coat layer having a thickness of 2 μm. Further, also on the other principal plane of the polymeric piezoelectric film, a hard coat layer having a thickness of 2 μm was formed in a similar manner, thereby obtaining a polymeric piezoelectric film on both surfaces of which hard coat layers are formed.
The same measurement and evaluation as in Example 1 were performed on the obtained polymeric piezoelectric film and an OCA stuck product manufactured from the film in a similar manner to Example 1. In the present Example, since similar hard coat layers were formed on both surfaces of the polymeric piezoelectric film, one surface thereof was used as a measuring surface for the non-contact three-dimensional surface roughness Sa.

[Comparative Example 1]

A polylactic acid (PLA) (trade name: Ingeo™ biopolymer, brand name: 4032D, weight average molecular weight Mw: 200,000) manufactured by NatureWorks LLC as a helical chiral polymer was placed in a hopper of an extrusion molding machine, extruded from a T-die while being heated at from 220°C to 230°C, and brought into contact with a cast roll (surface roughness Ra = 0.05 μm) at 50°C for 0.3 minutes to form a pre-crystallized sheet having a thickness of 230 μm (molding step). While the obtained pre-crystallized film was heated at 80°C, simultaneous biaxial stretching was performed by a tenter method up to 4.4 times in the TD direction and up to 2.0 times in the MD direction, to obtain a film (stretching step).
The film after the stretching step was annealed in a furnace heated at 145°C and quenched to manufacture a polymeric piezoelectric film (annealing treatment step). The quenching was performed by contacting the film after annealing with atmosphere at from 20°C to 30°C, and further contacting the film with a metal roll of a film winder, whereby the film temperature was rapidly cooled to around room temperature. The same measurement and evaluation as in Example 1 were performed on the obtained polymeric piezoelectric film and an OCA stuck product manufactured from the film in a similar manner to Example 1.

[Comparative Example 2]

A polymeric piezoelectric film was manufactured in a similar manner to Example 1 except that the cast roll was changed to a cast roll having a surface roughness Ra = 0.02 μm in the molding step, the roll was changed to a roll having a surface roughness Ra = 0.02 μm in the annealing step, and further, heating of a pre-crystallized film was changed from roll heating to IR heater heating (heating by a IR heater such that the actual temperature of the film measured by a radiation thermometer was 70°C).
The same measurement and evaluation as in Example 1 were performed on the obtained polymeric piezoelectric film and an OCA stuck product manufactured from the film in a similar manner to Example 1.

[Comparative Example 3]

A polymeric piezoelectric film was manufactured in a similar manner to Example 1 except that the cast roll was changed to a cast roll having a surface roughness Ra = 1.0 μm in the molding step.

The same measurement and evaluation as in Example 1 were performed on the obtained polymeric piezoelectric film and an OCA stuck product manufactured from the film in a similar manner to Example 1.

[Comparative Example 4]

A polylactic acid (PLA) (trade name: Ingeo™ biopolymer, brand name: 4032D, weight average molecular weight Mw: 200,000) manufactured by NatureWorks LLC as a helical chiral polymer was placed in a hopper of an extrusion molding machine, extruded from a T-die having a width of 2,000 mm while being heated at from 220°C to 230°C, and brought into contact with a cast roll (surface roughness Ra = 0.2 μm) at 50°C for 0.5 minutes to form a unstretched film having a thickness of 50 μm (molding step).

The same measurement and evaluation as in Example 1 were performed on the obtained unstretched film and an OCA stuck product manufactured from the film in a similar manner to Example 1.

[Reference Example]

A polymeric piezoelectric film was manufactured in a similar manner to Example 1 except that a polylactic acid to which 0.1 part by mass of silica (AZ-204 manufactured by Tosoh Silica Corporation) having an average particle size of 1.3 μm was added was placed in a hopper of an extrusion molding machine in the molding step.

The same measurement of the non-contact three-dimensional surface roughness Sa as in Example 1 was performed on the obtained polymeric piezoelectric film.

Results of the measurements and the evaluations for Examples 1 to 3, Comparative Examples 1 to 4, and Reference Example are listed on Table 1.

[Table 1]

| | Polymeric piezoelectric film | | | | | | | OCA stuck product | |
|---|---|---|---|---|---|---|---|---|---|
| | Three-dimensional surface roughness Sa [μm] | Internal haze [%] | Crystallinity [%] | MORc | Product of crystallinity and MORc | Piezoelectric constant (pC/N) | Charged voltage [kV] | Internal haze [%] | Appearance |
| Example 1 | 0.067 | 0.28 | 40.1 | 4.46 | 179 | 6.4 | 2.3 | 0.52 | A |
| Example 2 | 0.094 | 0.21 | 37.8 | 4.32 | 163 | 6.6 | 3.4 | 0.87 | B |
| Example 3 | 0.047 | 0.13 | 38.9 | 4.51 | 175 | 6.5 | 4.2 | 0.55 | A |
| Comparative Example 1 | 0.027 | 0.10 | 43.4 | 4.04 | 175 | 7.0 | 8.3 | 0.56 | A |
| Comparative Example 2 | 0.034 | 0.24 | 42.1 | 4.61 | 194 | 6.8 | 6.9 | 0.71 | A |
| Comparative Example 3 | 0.109 | 0.27 | 37.3 | 4.48 | 167 | 6.3 | 2.0 | 2.48 | C |
| Comparative Example 4 | 0.091 | 0.35 | 4.1 | 1.03 | 4 | 0.0 | 0.5 | 0.82 | A |
| Reference Example | 0.078 | 1.92 | - | - | - | - | - | - | - |

As shown in Table 1, in Examples 1 to 3 in which the non-contact three-dimensional surface roughness Sa was from 0.040 μm to 0.105 μm, generation of a surface charge (charged voltage) was suppressed, and the appearance after sticking together was excellent. On the other hand, in Comparative Examples 1 and 2 in which the non-contact three-dimensional surface roughness Sa was less than 0.040 μm, a value of the surface charge was high, and in Comparative Example 3 in which the non-contact three-dimensional surface roughness Sa was larger than 0.105 μm, a value of the internal haze of the OCA stuck product after an OCA was stuck together was high, and large air inclusions were scattered between the OCA and the polymeric piezoelectric film after the OCA was stuck together, resulting in a disadvantage in the appearance.

It was found that, in Comparative Example 4 (unstretched film) in which the crystallinity is less than 20%, and the product of the crystallinity and the standardized molecular orientation MORc was less than 25, the piezoelectric constant was 0, and the film cannot be used as a polymeric piezoelectric film.

It was found that, in Reference Example in which silica which is an inorganic filler was added to a polylactic acid in advance, the surface roughness during formation of a film was favorable, and the internal haze was high compared with Examples 1 to 3.

Japanese Patent Application No. 2014-169671 filed on August 22, 2014 is incorporated herein by reference in its entirety.

All the documents, patent applications, and technical standards described here are incorporated herein by reference to the same extent as the case in which each individual document, patent application, or technical standard is specifically and individually indicated to be incorporated by reference.

## Claims

1. A polymeric piezoelectric film containing an optically active helical chiral polymer (A) having a weight average molecular weight of from 50,000 to 1,000,000, wherein a crystallinity obtained by a DSC method is from 20% to 80%, and a product of the crystallinity and a standardized molecular orientation MORc, when a reference thickness measured by a microwave transmission-type molecular orientation meter is set to 50 μm, is from 25 to 700, and wherein a surface roughness of at least one plane in terms of a non-contact three-dimensional surface roughness Sa measured by a confocal laser microscope is from 0.040 μm to 0.105 μm.

2. The polymeric piezoelectric film according to claim 1, wherein an internal haze for visible light is 40% or less, and a piezoelectric constant $d_{14}$ measured by a stress-electric charge method at 25°C is 1 pC/N or more.

3. The polymeric piezoelectric film according to claim 1 or 2, wherein an internal haze for visible light is 20% or less.

4. The polymeric piezoelectric film according to any one of claims 1 to 3, wherein the product of the crystallinity and the standardized molecular orientation MORc is from 40 to 700.

5. The polymeric piezoelectric film according to any one of claims 1 to 4, wherein the helical chiral polymer (A) is a polylactic acid polymer having a repeating unit represented by the following Formula (1)

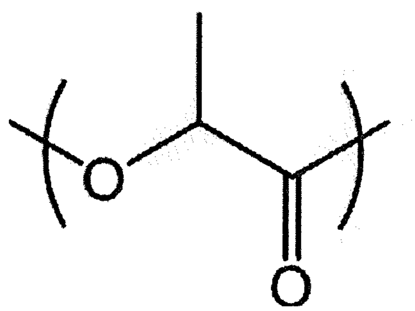

(1)

.

6. The polymeric piezoelectric film according to any one of claims 1 to 5, wherein the helical chiral polymer (A) has an optical purity of 95.00%ee or more.

7. The polymeric piezoelectric film according to any one of claims 1 to 6, wherein a content of the helical chiral polymer (A) is 80% by mass or more.

**8.** The polymeric piezoelectric film according to any one of claims 1 to 7, wherein an internal haze for visible light is 1% or less.

**INTERNATIONAL SEARCH REPORT**

International application No.
PCT/JP2015/069959

A. CLASSIFICATION OF SUBJECT MATTER
*H01L41/193*(2006.01)i, *C08J5/18*(2006.01)i

According to International Patent Classification (IPC) or to both national classification and IPC

B. FIELDS SEARCHED

Minimum documentation searched (classification system followed by classification symbols)
H01L41/193, C08J5/18, G06F3/041, H04R17/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2014-086703 A (Mitsui Chemicals, Inc.), 12 May 2014 (12.05.2014), paragraphs [0020] to [0128] (Family: none) | 1-8 |
| Y | WO 2010/061726 A1 (Konica Minolta Medical & Graphic, Inc.), 03 June 2010 (03.06.2010), paragraphs [0023] to [0026]; table 1 (Family: none) | 1-8 |
| A | JP 2013-199649 A (Mitsui Chemicals, Inc.), 03 October 2013 (03.10.2013), entire text & JP 5259026 B & US 2014/0084204 A1 & WO 2013/054918 A1 & EP 2672539 A1 & CN 103380505 A & KR 10-2013-0120505 A | 1-8 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 September 2015 (16.09.15) | 06 October 2015 (06.10.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

INTERNATIONAL SEARCH REPORT

International application No.
PCT/JP2015/069959

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2010-254794 A (Oji Paper Co., Ltd.), 11 November 2010 (11.11.2010), paragraphs [0068] to [0073] (Family: none) | 1-8 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000044701 A
- JP 2001059029 A
- JP 2009285865 A
- JP S59096123 A
- JP H7033861 A
- US 2668182 A
- US 4057357 A
- WO 2013054918 A
- JP 2014169671 A